(19)

**Europäisches Patentamt**
**European Patent Office**
**Office européen des brevets**

(11) **EP 1 889 887 A1**

(12) **EUROPEAN PATENT APPLICATION**

(43) Date of publication:
**20.02.2008 Bulletin 2008/08**

(51) Int Cl.:
*C09J 7/00* (2006.01)

(21) Application number: **07015793.8**

(22) Date of filing: **10.08.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **14.08.2006 JP 2006220839**

(71) Applicant: **NITTO DENKO CORPORATION Osaka (JP)**

(72) Inventors:
- **Hirayama, Takamasa**
  **Ibaraki-shi,**
  **Osaka (JP)**
- **Kiuchi, Kazuyuki**
  **Ibaraki-shi,**
  **Osaka (JP)**

- **Sato, Masaaki**
  **Ibaraki-shi,**
  **Osaka (JP)**
- **Arimitsu, Yukio**
  **Ibaraki-shi,**
  **Osaka (JP)**
- **Shimokawa, Daisuke**
  **Ibaraki-shi,**
  **Osaka (JP)**
- **Kishimoto, Tomoko**
  **Ibaraki-shi,**
  **Osaka (JP)**

(74) Representative: **Grünecker, Kinkeldey, Stockmair & Schwanhäusser Anwaltssozietät Maximilianstrasse 58 80538 München (DE)**

(54) **Adhesive sheet, process for producing the same, and method of cutting multilayered ceramic sheet**

(57)    The present invention relates to an adhesive sheet including a substrate and, an adherent layer containing heat-expandable microspheres, the adherent layer being disposed on at least one side of the substrate, in which the adherent layer has a thickness of 10 to 38 $\mu$m, and wherein the heat-expandable microspheres have a maximum particle diameter equal to or smaller than the thickness of the adherent layer and have a mode diameter of 5 to 30 $\mu$m. The adhesive sheet of the invention enables a high-accuracy processing in the step of processing an electronic part such as a small ceramic capacitor to thereby greatly improve product characteristics and productivity.

## FIG. 3

EP 1 889 887 A1

**Description**

**FIELD OF THE INVENTION**

The present invention relates to a heat-peelable adhesive sheet. More particularly, the invention relates to a heat-peelable adhesive sheet for use in, e.g., a step in the production of ceramic capacitors.

**BACKGROUND OF THE INVENTION**

Adhesive sheets employing an adhesive containing spherical particles dispersed therein for the purposes of improving the cohesiveness of the adhesive, imparting electrical conductivity thereto, etc. have been used in various fields. Of these, heat-peelable adhesive sheets employing an adhesive containing heat-expandable microspheres dispersed therein are in extensive use in electronic-part processing applications. For example, heat-peelable adhesive sheets including a substrate and formed thereon a pressure-sensitive adhesive layer containing a blowing agent or expanding agent such as heat-expandable microspheres, are known (see, for example, patent documents 1 to 5). The feature of these heat-peelable adhesive sheets resides in that the blowing agent expands upon heating to reduce adhesive force and the adhesive sheets thus become easily peelable from the adherend. Namely, these adhesive sheets combine adhesiveness and peelability after use.

However, those heat-peelable adhesive sheets have the following drawback. Since the heat-expandable microspheres contained in the adherent layer include particles having a relatively large particle diameter, it is necessary to regulate the adherent layer so as to be thick in some degree to thereby maintain the surface smoothness of the heat-peelable layer (adherent layer). Because of this, as a result of the recent trend toward weight and thickness reduction and miniaturization in electronic parts, the thickness of the adherent layer has come to pose problems in electronic-part processing required to attain a high degree of processing accuracy. Namely, the thick adherent layer has come to pose problems, for example, that the work to be cut suffers positional shifting and the work is pushed into the adherent layer and is hence cut obliquely. Also in the field of, e.g., ceramic capacitors, miniaturization represented by the 0603 size (0.6 mm × 0.3 mm) and 0402 size (0.4 mm × 0.2 mm) and capacitance increase by superposing more than some hundreds of layers are becoming remarkable with the progress of mounting techniques. Under these circumstances, a heat-peelable adhesive sheet in which the adherent layer on the supporting substrate has a small thickness has come to be desired so as to attain a reduced deformation amount during cutting in a production step.

In order to overcome the problems described above, it may be considered to remove large particles by centrifugal classification or the like, However, the use of conventional classification techniques results not only in the removal of large particles but in a decrease in mode diameter (particle diameter at which the relative particle amount in a particle diameter-relative particle amount histogram is maximal) and, hence, it becomes unable to obtain sufficient heat peelability.

Namely, an effective technique which simultaneously attains heat peelability, surface smoothness, and a reduced adherent-layer thickness has not been obtained so far.

Patent Document 1 :    JP-UM-B-50-13878
Patent Document 2 :    JP-B-51-24534
Patent Document 3 :    JP-A-56-61468
Patent Document 4 :    JP-A-56-61469

Patent Document 5 :    JP-A-60-252681

**SUMMARY OF THE INVENTION**

An object of the invention is to solve the above-mentioned problems and provide an adhesive sheet which can simultaneously attain heat peelability, surface smoothness, and a reduction in adherent-layer thickness owing to the use of heat-expandable microspheres from which particles having a large diameter have been removed while maintaining a mode diameter.

The present inventors have made intensive investigations in order to accomplish the object. As a result, they found that by using a filter, large particles can be removed from heat-expandable microspheres without reducing the mode diameter thereof and that a heat-peelable adhesive sheet having satisfactory surface smoothness and having a heat-expandable adherent layer with a reduced thickness can hence be produced. They further found that by subjecting the substrate to a surface treatment, such adhesive sheet in which the adherent layer, although thin, is satisfactorily anchored to the substrate can be obtained. The invention has been thus completed.

**BRIEF DESCRIPTION OF THE DRAWINGS**

Fig. 1 is a diagrammatic sectional view illustrating one embodiment of the adhesive sheet of the invention (wherein the adherent layer is constituted of one layer).

Fig. 2 is a diagrammatic sectional view illustrating another embodiment of the adhesive sheet of the invention (wherein the adherent layer is constituted of two layers).

Fig. 3 is a diagrammatic sectional view of a chip, the view showing a method of calculating the accuracy of the cutting of a multilayered ceramic sheet.

Description of the Reference Numerals

1    adhesive sheet (having adherent layer constituted of one layer)
2    substrate
3    adherent layer (one layer)
4    separator
5    heat-expandable microsphere
6    adhesive sheet (having adherent layer constituted of two layers)
7    substrate
8    adherent layer (two layers)
9    resin layer
10   adhesive layer
11   separator
12   heat-expandable microsphere
13   chip

**DETAILED DESCRIPTION OF THE INVENTION**

Namely, the present invention relates to the following (1) to (24).

(1) An adhesive sheet comprising:

a substrate; and,
an adherent layer containing heat-expandable microspheres, the adherent layer being disposed on at least one side of the substrate,

wherein the adherent layer has a thickness of 10 to 38 $\mu$m, and
wherein the heat-expandable microspheres have a maximum particle diameter equal to or smaller than the thickness of the adherent layer and have a mode diameter of 5 to 30 $\mu$m.

(2) The adhesive sheet according to (1), wherein the adherent layer is constituted of an acrylic adhesive.

(3) The adhesive sheet according to (1), wherein a surface of the substrate on which the adherent layer is disposed has been subjected to a surface treatment.

(4) The adhesive sheet according to (3), wherein the surface treatment is at least one member selected from the group consisting of a surface-roughening treatment, a surface treatment with a chemical, and a surface treatment with electromagnetic wave irradiation.

(5) The adhesive sheet according to (4), wherein the surface-roughening treatment is at least one member selected from the group consisting of matting, sandblasting, and embossing.

(6) The adhesive sheet according to (4), wherein the surface treatment with a chemical is a dichromate treatment or a sodium hydroxide treatment.

(7) The adhesive sheet according to (4), wherein the surface treatment with electromagnetic wave irradiation is a corona treatment or a sputtering treatment.

(8) The adhesive sheet according to (1), wherein the maximum particle diameter of the heat-expandable microspheres has been regulated so as to be equal to or smaller than the thickness of the adherent layer by filtration using a filter.

(9) An adhesive sheet comprising: '

a substrate; and,

an adherent layer which is disposed on at least one side of the substrate,

the adherent layer comprising a resin layer containing heat-expandable microspheres and an adhesive layer,

the adhesive layer being disposed on a side of the resin layer which is opposite to the substrate side of the resin layer,

wherein the adherent layer has a thickness of 10 to 38 $\mu$m, and

wherein the heat-expandable microspheres have a maximum particle diameter equal to or smaller than the thickness of the adherent layer and have a mode diameter of 5 to 30 $\mu$m.

(10) The adhesive sheet according to (9), wherein the adherent layer is constituted of an acrylic adhesive.

(11) The adhesive sheet according to (9), wherein a surface of the substrate on which the adherent layer is disposed has been subjected to a surface treatment.

(12) The adhesive sheet according to (11), wherein the surface treatment is at least one member selected from the group consisting of a surface-roughening treatment, a surface treatment with a chemical, and a surface treatment with electromagnetic wave irradiation.

(13) The adhesive sheet according to (12), wherein the surface-roughening treatment is at least one member selected from the group consisting of matting, sandblasting, and embossing.

(14) The adhesive sheet according to (12), wherein the surface treatment with a chemical is a dichromate treatment or a sodium hydroxide treatment.

(15) The adhesive sheet according to (12), wherein the surface treatment with electromagnetic wave irradiation is a corona treatment or a sputtering treatment.

(16) The adhesive sheet according to (9), wherein the maximum particle diameter of the heat-expandable microspheres has been regulated so as to be equal to or smaller than the thickness of the adherent layer by filtration using a filter.

(17) A process for producing an adhesive sheet, which comprises:

filtering heat-expandable microspheres through a filter to regulate the heat-expandable microspheres so as to have a maximum particle diameter equal to or smaller than a thickness of an adherent layer to be formed and have a mode diameter of 5 to 30 $\mu$m; and then

forming said adherent layer containing the heat-expandable microspheres on a substrate so as to have a thickness of 10 to 38 $\mu$m.

(18) The process for producing an adhesive sheet according to claim (17), wherein a surface of the substrate on which the adherent layer is to be formed is subjected to a surface treatment before the formation of the adherent layer.

(19) The adhesive sheet according to (1), which is for use in provisional fixing in an electronic-part processing step.

(20) The adhesive sheet according to (9), which is for use in provisional fixing in an electronic-part processing step.

(21) The adhesive sheet of according to (1), which is for use in cutting a multilayered ceramic sheet.

(22) The adhesive sheet of according to (9), which is for use in cutting a multilayered ceramic sheet.

(23) A method of cutting a multilayered ceramic sheet, which comprises:

applying the adhesive sheet according to (21) to one surface of the multilayered ceramic sheet;

cutting the multilayered ceramic sheet into chips; and

heating the adhesive sheet to reduce the adhesive force of the adherent layer, followed by separating the chips from the adhesive sheet.

(24) A method of cutting a multilayered ceramic sheet, which comprises:

applying the adhesive sheet according to (22) to one surface of the multilayered ceramic sheet;

cutting the multilayered ceramic sheet into chips; and

heating the adhesive sheet to reduce the adhesive force of the adherent layer, followed by separating the chips from the adhesive sheet.

The adhesive sheet of the invention enables a high-accuracy processing in the step of processing an electronic part such as a small ceramic capacitor to thereby greatly improve product characteristics and productivity. The adhesive sheet is hence industrially useful.

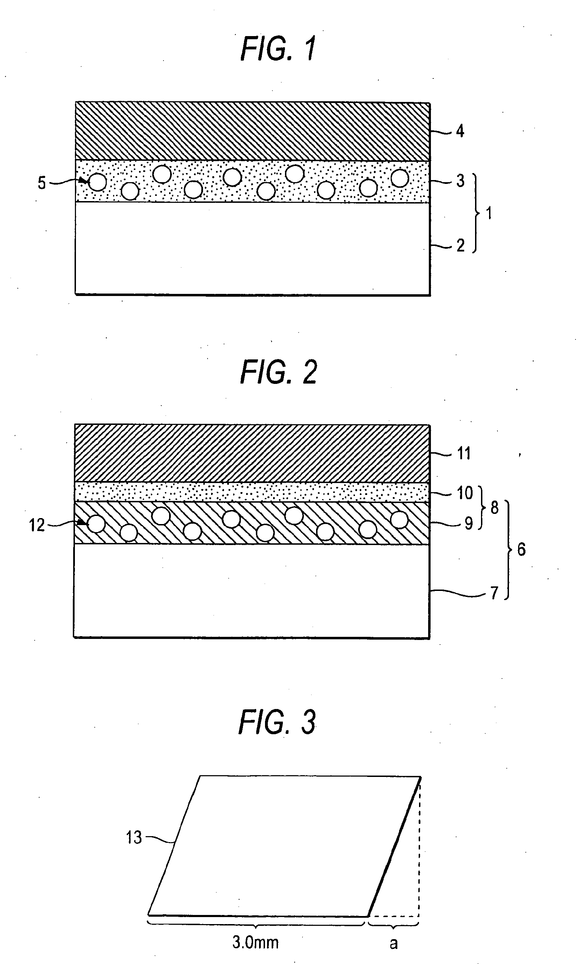

Embodiments of the invention are explained below by reference to accompanying drawings. Fig. 1 is a diagrammatic sectional view illustrating one embodiment of the adhesive sheet of the invention (in the case where the adherent layer is constituted of one layer). The adhesive sheet 1 shown in Fig. 1 includes a substrate 2 and, disposed on one side thereof, an adherent layer 3 containing heat-expandable microspheres 5. It is preferred that a separator 4 (release film) be provisionally attached to the adherent layer 3 until the adhesive sheet 1 is used. Fig. 2 is a diagrammatic sectional view illustrating another embodiment of the adhesive sheet of the invention (in the case where the adherent layer is constituted of two layers). The adhesive sheet 6 shown in Fig. 2 includes a substrate 7 and, disposed on one side thereof an adherent layer 8 having two-layers composed of a resin layer 9 containing heat-expandable microspheres 12 and an adhesive layer I0. It is preferred that a separator 11 (release film) be provisionally attached to the adhesive layer 10 until the adhesive sheet 6 is used.

The adhesive sheet of the invention has a structure including a substrate and, disposed on at least one side thereof, an adherent layer containing heat-expandable microspheres. The adherent layer may be disposed directly on the substrate without via any layer, or an interlayer may be disposed between the substrate and the adherent layer. The surface of the substrate on which the adherent layer is to be disposed may be subjected to a surface treatment in the manner which will be described later. It is preferable to conduct such surface treatment because a satisfactory anchoring effect is obtained without the interposition of a rubbery organic elastic layer or the like. From the standpoint of exhibiting adhesive properties, the adherent layer is preferably disposed as the outermost layer of the adhesive sheet. In the case where the adhesive sheet has a separator, the adherent layer is preferably disposed as the outermost layer after separator removal. The adherent layer may be disposed on each side of the substrate. Alternatively, an ordinary pressure-sensitive adhesive layer containing no heat-expandable microspheres may be disposed on the side of the substrate which is opposite to the side on which the adherent layer described above is disposed.

Substrate

The substrate to be used in the adhesive sheet of the invention is a layer serving as a support, and exerts considerable influences on properties of the adhesive sheet, such as strength and heat shrinkage, sheet handleability, etc. As the substrate, plastic films and other various sheet-form materials such as paper, fabrics, nonwoven fabrics, metal foils, plastic laminates of these, and laminates of plastics can, for example, be used. From the standpoints of handleability and cost, plastic films and plastic sheets (hereinafter inclusively referred to as plastic films) are most preferred of those. Materials of the plastic films can be suitably selected according to the necessity from the standpoints of strength, heat resistance, etc. Examples thereof include olefin resins obtained from one or more monomer ingredients including an $\alpha$-olefin, such as polyethylene (PE), polypropylene (PP), ethylene/propylene copolymers, and ethylene/ vinyl acetate copolymer (EVA); polyesters such as poly(ethylene terephthalate) (PET), poly(ethylene naphthalate) (PEN), and poly(butylene terephthalate) (PBT); poly(vinyl chloride) (PVC); poly(phenylene sulfide) (PPS); amide resins such as polyamides (nylons) and wholly aromatic polyamides (aramids); and polyetheretherketones (PEEK), polyimides, polyetherimides, polystyrene, and acrylic resins. These materials can be used alone or in combination of two or more thereof The plastic film to be used may be any of unstretched film, uniaxially stretched film, and biaxially stretched film. Furthermore, the plastic film may be a laminated film composed of two or more film layers.

The thickness of the substrate varies according to the intended use, etc., and is not particularly limited. However, it is generally 500 $\mu$m or smaller (e.g., 1 to 500 $\mu$m), preferably 1 to 300 $\mu$m, more preferably 5 to 250 $\mu$m.

It is preferred that the surface of the substrate on which the adherent layer (adherent layer according to the invention) is to be disposed have been subjected to a surface treatment for improving adhesion between the substrate and the adherent layer. The surface treatment enables the adhesive sheet to be equal in properties, such as anchoring, to heat-peelable adhesive sheets conventionally in use even when the adherent layer is directly formed on the substrate without via a rubbery organic elastic layer unlike the adherent layer in the conventional heat-peelable adhesive sheets. In the case where a rubbery organic elastic layer is not formed, the total thickness of the layers to be formed on the substrate can be reduced. This is preferred because processing accuracy in cutting or other processing can be further improved.

As the surface treatment, conventional and common surface treatments can be used. For example, use may be made of a method by which the surface is physically or chemically roughened or a method by which chemical properties of the surface are modified by, e.g., a treatment with a chemical. Examples of such surface treatment methods include a mechanical/physical or chemical surface-roughening treatment, a surface treatment with electromagnetic wave irradiation, a chemical surface treatment with a chemical, an ozone exposure treatment, and a flame exposure treatment. Preferred of these are a mechanical/physical surface-roughening treatment, a surface treatment with electromagnetic wave irradiation, and a chemical surface treatment with a chemical.

The mechanical/physical surface-roughening treatment is a treatment for forming irregularities on the substrate surface. This treatment can improve adhesion of the substrate to the adherent layer based on an anchoring effect. Examples of the mechanical/physical surface-roughening treatment include a method in which a substrate is produced which has surface irregularities imparted thereto during the production thereof and a method in which a substrate having a smooth surface is matted.

Typical examples of the method in which surface irregularities are imparted during substrate production include embossing. The term "embossing" herein means a method in which a film is sufficiently heated and then pressed against a heated metallic roll whose surface has been engraved so as to have a pattern suitable for the intended use or a satin finish to thereby transfer the pattern or satin finish to the substrate surface. In general, a film is processed by passing it through the nip between a metallic roll having a diameter of about 10 to 30 cm and a paper or rubber roll. Embossing is effective when the substrate is a film which is apt to soften at relatively low temperatures, such as poly(vinyl chloride).

On the other hand, the method in which a substrate having a smooth surface is matted preferably is a mechanical matting treatment from the standpoint of obtaining sufficient surface roughness. Examples thereof include: a method in which a surface of a supporting substrate is polished with a buff or sandpaper; and sandblasting in which particles such as glass beads, carborundum, or metal particles are blown against a substrate surface at a high speed together with compressed air to finely mar the surface. Sandblasting is preferred because it is easy to regulate the degree of surface roughening by selecting the material of the particles to be blown or changing blowing conditions.

The arithmetic average roughness Ra of the substrate which has undergone the surface-roughening treatment is preferably 0.1 to 0.7 $\mu$m, and more preferably 0.2 to 0.6 $\mu$m. The maximum height Ry thereof is preferably 2 to 9 $\mu$m, and more preferably 3 to 7 $\mu$m. The ten-point average roughness Rz is preferably 2 to 9 $\mu$m, and more preferably 3 to 7 $\mu$m. When the Ra, Ry, and Rz of the substrate surface are within those ranges, the surface smoothness of the adherent layer and the anchoring of the adherent layer to the substrate can be reconciled. When the Ra, Ry, or Rz thereof exceeds the upper limit, there are cases where the adherent layer of the adhesive sheet has a rough surface and this adhesive sheet has reduced adhesive properties and is unsuitable for microfabrication. On the other hand, in the case where the Ra, Ry, or Rz thereof is lower than the lower limit, the effect of improving the anchoring of the adherent layer to the substrate is less apt to be obtained.

According to each of the surface treatment with electromagnetic wave irradiation and the chemical surface treatment with a chemical, oxygen-containing functional groups such as hydroxyl groups or carboxyl groups can be incorporated into the substrate surface to thereby improve adhesion to the adherent layer based on the effect of forming hydrogen bonds or the like. Examples of the surface treatment with electromagnetic wave irradiation include a corona discharge treatment, plasma discharge treatment, sputtering treatment, ultraviolet irradiation treatment, electron beam irradiation treatment, and ozone irradiation treatment. Preferred of these are a corona discharge treatment (corona treatment) and a sputtering treatment. Examples of treating liquids usable in the chemical surface treatment with a chemical include potassium dichromate/concentrated sulfuric acid/water, sodium hypochlorite/concentrated hydrochloric acid/water, sodium metal/naphthalene/tetrahydrofuran, sodium p-toluenesulfonate, sodium hydroxide/water, potassium permanganate/concentrated sulfuric acid/water, and ammonium persulfate/water. Preferred of these are potassium dichromate/concentrated sulfuric acid/water (referred to as dichromate treatment) and sodium hydroxide/water (referred to as sodium hydroxide treatment).

With regard to the substrate, the side on which the adherent layer according to the invention is not to be disposed may also have subjected to a surface treatment. This treatment also can be conducted by an ordinary surface treatment method. For example, a chemical or physical oxidation treatment such as a chromate treatment, ozone exposure, flame exposure, exposure to a high-tension electric shock, or treatment with an ionizing radiation may be conducted for the purpose of imparting adhesion to other layers. Conversely, in the case of imparting release properties, that side may be subjected to a coating treatment with a release agent such as a silicone resin or a fluororesin.

Adherent Layer

The adherent layer according to the invention can have two embodiments. One embodiment is an adherent layer constituted of one layer containing an adhesive substance (adhesive) for imparting adhesive properties and heat-expandable microspheres. The other embodiment is an adherent layer constituted of two layers, i.e., a resin layer containing heat-expandable microspheres and, superposed thereon, a layer of an adhesive (adhesive layer) containing substantially no heat-expandable microspheres. In the adherent layer of the two-layer constitution, the adhesive layer is disposed on the side of the resin layer containing heat-expandable microspheres, which is opposite to the side on which the substrate is disposed. Namely, substrate, resin layer containing heat-expandable microspheres, and adherent layer are laminated in this order. The adherent layer according to the invention is an adherent layer which is heat-expandable. In the former embodiment, one adherent layer combines two functions, i.e., adhesive properties and heat expansibility. In contrast, in the latter embodiment, the functions are allotted separately to the heat-expandable layer having heat expansibility and the adhesive layer serving to have adhesive properties.

The adhesive to be used in the adherent layer can be an ordinary adhesive. In general, however, it is preferred to use an adhesive of the water activation or organic-solvent activation type or a pressure-sensitive adhesive.

Examples of the pressure-sensitive adhesive include rubber-based pressure-sensitive adhesives, acrylic pressure-sensitive adhesives, styrene/conjugated diene block copolymer pressure-sensitive adhesives, silicone pressure-sensitive adhesives, ultraviolet-curable pressure-sensitive adhesives, and pressure-sensitive adhesives containing a heat-fusible resin with a low melting point (in particular, a melting point of 200°C or lower) and having improved creep characteristics (see, for example, JP-A-56-61483, JP-A-61-174857, JP-A-63-17981, and JP-A-56-13040).

Examples of the rubber-based pressure-sensitive adhesives include pressure-sensitive adhesives employing natural rubber or any of various synthetic rubbers as the base polymer, and pressure-sensitive adhesives employing a silicone rubber represented by dimethylpolysiloxane as the base polymer.

Examples of the acrylic pressure-sensitive adhesives include pressure-sensitive adhesives employing, as the base polymer, an acrylic polymer (homopolymer or copolymer) obtained from one or more monomer ingredients selected from alkyl esters of (meth)acrylic acid (e.g., $C_{1-20}$-alkyl esters of (meth)acrylic acid, such as the methyl ester, ethyl ester, propyl ester, isopropyl ester, butyl ester, isobutyl ester, s-butyl ester, t-butyl ester, pentyl ester, hexyl ester, heptyl ester, octyl ester, 2-ethylhexyl ester, isooctyl ester, isodecyl ester, dodecyl ester, tridecyl ester, pentadecyl ester, hexadecyl ester, heptadecyl ester, octadecyl ester, nonadecyl ester, and eicosyl ester) and cycloalkyl esters of (meth)acrylic acid (e.g., $C_{3-20}$-cycloalkyl esters such as the cyclopentyl ester and cyclohexyl ester).

As an acrylic pressure-sensitive adhesive, use may be made of a pressure-sensitive adhesive employing as the base polymer a copolymer of any of the alkyl esters (or cycloalkyl esters) of (meth)acrylic acid and one or more other monomer ingredients used for the purpose of modifying adhesive properties, etc. Examples of such monomer ingredients (comonomers) include carboxyl-containing monomers such as acrylic acid, methacrylic acid, carboxyethyl acrylate, carboxypentyl acrylate, itaconic acid, maleic acid, fumaric acid, and crotonic acid; acid anhydride monomers such as maleic anhydride and itaconic anhydride; hydroxyl-containing monomers such as 2-hydroxyethyl (meth)acrylate, 2-hydroxypropyl (meth)acrylate, and 4-hydroxybutyl (meth)acrylate; sulfo-containing monomers such as styrenesulfonic acid, arylsulfonic acids, 2-(meth)acrylamido-2-methylpropanesulfonic acid, and (meth)acrylamidopropanesulfonic acid; phosphate-group-containing monomers such as 2-hydroxyethyl acryloylphosphate; (N-substituted) amide monomers such as (meth)acrylamide, N-butyl(meth)acrylamide, N-methylol(meth)acrylamide, and N-methylolpropane(meth)acrylamide; aminoalkyl (meth)acrylate monomers such as aminoethyl (meth)acrylate and N,N-dimethylaminoethyl (meth)acrylate; alkoxyalkyl (meth)acrylate monomers such as methoxyethyl (meth)acrylate and ethoxyethyl (meth)acrylate; maleimide monomers such as N-cyclohexylmaleimide and N-isopropylmaleimide; itaconimide monomers such as N-methylitaconimide and N-ethylitaconimide; succinimide monomers such as N-(meth)acryloyloxymethylenesuccinimide and N-(meth)acryloyl-6-oxyhexamethylenesuccinimide; vinyl monomers such as vinyl acetate, vinyl propionate, N-vinylpyrrolidone, methylvinylpyrrolidone, styrene, and $\alpha$-methylstyrene; cyanoacrylate monomers such as acrylonitrile and methacrylonitrile; epoxy-group-containing acrylic monomers such as glycidyl (meth)acrylate; glycol acrylic ester monomers such as polyethylene glycol (meth)acrylate and polypropylene glycol (meth)acrylate; acrylic ester monomers having one or more heterocycles, halogen atoms, silicon atoms, or the like, such as tetrahydrofurfuryl (meth)acrylate, fluoro (meth)acrylates, and silicone (meth)acrylates; polyfunctional monomers such as hexanediol (meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy acrylates, polyester acrylates, and urethane acrylates; olefin monomers such as isoprene, butadiene, and isobutylene; and vinyl ether monomers such as vinyl ether. These monomer ingredients can be used alone or in combination of two or more thereof.

Of those adhesives, the pressure-sensitive adhesives are especially preferred from the standpoint of ease of application to adherends. In the case where an adhesive and heat-expandable microspheres are contained in the same layer, i.e., when the adhesive sheet employs the heat-expandable adhesive layer, it is preferred to select and use an adhesive which restrains the foaming and expansion of the heat-expandable microspheres as less as possible. Examples of such adhesive include acrylic adhesives, silicone adhesives, and natural-rubber adhesives. The adhesives described above can be used alone or in combination of two or more thereof.

Besides the above-mentioned adhesive, suitable additives may be incorporated into the adherent layer. Examples of the additives include crosslinking agents (e.g., isocyanate crosslinking agents and epoxy crosslinking agents), tackifiers (e.g., rosin derivative resins, polyterpene resins, petroleum resins, and oil-soluble phenolic resins), plasticizers, fillers, and antioxidants.

In the case where the adherent layer according to the invention is constituted of separately formed two layers, i.e., a resin layer containing heat-expandable microspheres (heat-expandable layer) and an adhesive layer, the adhesive to be used for forming the adhesive layer can be any of the adhesives described above. The heat-expandable layer is constituted of heat-expandable microspheres and a binder. Although the binder is not particularly limited, it preferably is a compound which does not inhibit the heat-expandable microspheres from foaming or expanding. For example, a polymeric compound of the rubber type, resin type, or the like is used. Specific examples of the binder include epoxy resins and rubber binders.

The heat-expandable microspheres (microcapsules) to be used in the invention are heat-expandable microspheres having a particle diameter of 0.1 to 38 $\mu$m. Since the adherent layer in the invention contains heat-expandable microspheres, it functions as a heat-expandable adherent layer which decreases efficiently in adhesive force upon heat treatment.

The adhesive sheet of the invention has the following advantages because it has the heat-expandable adherent layer. When the adhesive sheet is applied to an adherend (work) to fix it in preparation for a desired processing, the processing can be smoothly conducted because the work is tenaciously fixed. On the other hand, after the processing, the heat-expandable adherent layer is heated to expand the heat-expandable microspheres. As a result, the area of contact between the heat-expandable adherent layer and the adherend decreases and the adhesiveness is thus decreased. Accordingly, the processed work can be easily separated from the adhesive sheet without damaging it.

The heat-expandable microspheres for use in the invention can be suitably selected from conventional heat-expandable microspheres. Examples thereof include microspheres obtained by encapsulating a substance which readily gasifies and expands upon heating, such as isobutane, propane, or pentane, in elastic shells. In general, the shells are made of a heat-meltable substance or a substance which breaks upon heat expansion. Examples of such shell-forming substances include vinylidene chloride/acrylonitrile copolymers, poly(vinyl alcohol), poly(vinyl butyral), poly(methyl methacrylate), polyacrylonitrile, poly(vinylidene chloride), and polysulfones. The heat-expandable microspheres can be produced by an ordinary method such as the coacervation method or interfacial polymerization method. Examples of commercial products of the heat-expandable microspheres include trade name "Matsumoto Microsphere", manufactured by Matsumoto Yushi-Seiyaku Co., Ltd.

The degree of volume expansion (degree of volume expansion at, for example, about 80 to 140°C) of the heat-expandable microspheres for use in the invention is preferably 5 times or higher (e.g., 5 to 12 times), more preferably 7 times or higher (e.g., 7 to 12 times), even more preferably 10 times or higher (e.g., 10 to 12 times), from the standpoint of efficiently reducing the adhesive force of the adherent layer by heat treatment. The heat-expandable microspheres should have moderate strength which enables the microspheres not to break until they come to have such a degree of volume expansion. When heat-expandable microspheres which break at a low degree of expansion are used, there are cases where the area of adhesion between the adherent layer and an adherend is not sufficiently reduced and satisfactory peelability is not obtained.

The maximum particle diameter of the heat-expandable microspheres in the invention is equal to or smaller than the adherent-layer thickness which will be described later, and it is preferably 10 to 30 μm, and more preferably 10 to 20 μm. In the case where the maximum particle diameter of the heat-expandable microspheres is larger than the thickness of the adherent layer, the adherent layer has enhanced surface irregularities, resulting in reduced adhesive properties. Such too large maximum particle diameters are hence undesirable.

The mode diameter of the heat-expandable microspheres in the invention is 5 to 30 μm, preferably 6 to 25 μm, and more preferably 7 to 20 μm. In the case where the mode diameter of the heat-expandable microspheres is smaller than 5 μm, sufficient heat peelability cannot be obtained. In the case where it exceeds 30 μm, surface smoothness becomes poor, resulting in reduced adhesive properties.

According to the invention, the amount of the heat-expandable microspheres to be incorporated can be suitably regulated according to the desired degree of expansion of the adherent layer and the desired decrease in adhesive properties. In general, however, the amount thereof is preferably 10 to 200 parts by weight, more preferably 25 to 125 parts by weight, based on 100 parts by weight of the base polymer constituting the adherent layer.

The thickness of the adherent layer in the invention is 10 to 38 μm, preferably 15 to 35 μm, and more preferably 15 to 30 μm. When the thickness of the adherent layer exceeds 38 μm, there are cases where the adherent layer deforms during, e.g., the cutting of small electronic parts, resulting in reduced cutting accuracy, or where the adherent layer suffers a cohesive failure after expansion (blowing) to leave an adhesive residue on the adherend. In the case where the thickness of the adherent layer is smaller than 10 μm, the adherent layer has enhanced surface irregularities due to the heat-expandable microspheres, resulting in impaired surface smoothness and reduced adhesive force. From the standpoint of surface smoothness, the thickness of the adherent layer according to the invention should be larger than the maximum particle diameter of the heat-expandable microspheres. In the case where a resin layer containing heat-expandable microspheres (heat-expandable layer) and an adhesive layer are separately formed, the term "thickness of the adherent layer" means the total thickness of the resin layer and the adhesive layer. In the case where a rubbery organic elastic layer (a layer constituted of natural rubber, a synthetic rubber, or a synthetic resin having rubber elasticity which each has a Shore D hardness in accordance with ASTM D-2240 of 50 or lower) has been disposed between the substrate and the adherent layer, the total thickness of the layers including the elastic layer preferably is 38 μm or smaller. This is because the rubbery organic elastic layer may influence the deformation of the adhesive sheet like the adherent layer according to the invention.

The adherent layer according to the invention can be formed by an ordinary method. For example, it can be formed by a method in which a coating material containing an adhesive and heat-expandable microspheres and optionally containing a solvent and additives is applied to a substrate or a method in which the coating material is applied to an appropriate separator (e.g., release paper) to form an adherent layer and this adherent layer is transferred onto a substrate.

In the case where the adherent layer according to the invention is constituted of separately formed two layers, i.e., a resin layer containing heat-expandable microspheres (heat-expandable layer) and an adhesive layer, the resin layer can be formed by applying a coating material containing heat-expandable microspheres and a binder to a substrate.

The adhesive layer can be formed using an adhesive-containing coating fluid by the same method as for the adherent layer.

The heat-expandable microspheres to be used in the invention may be filtered through a filter. According to the filtration, large particles can be removed to thereby regulate the maximum particle diameter of the microspheres while maintaining a mode diameter in the range specified in the invention A filter system for application to high-viscosity adhesives may be used for the filtration. Such filter preferably is a cartridge filter for use in the filtration of, in particular, adhesives, coating materials, or the like. Examples thereof include Kanefil (R2410; AION Co., Ltd.) and Chisso Filter (CPII01-S; Chisso Filter Co., Ltd.),

The mesh size of the filter is not particularly limited so long as it is equal to or smaller than the thickness of the adherent layer. However, it is preferably 5 to 35 $\mu$m, and more preferably 10 to 25 $\mu$m. When the mesh size thereof exceeds 35 $\mu$m, there are cases where large particles having a diameter larger than the thickness of the adherent layer remain. When the mesh size thereof is smaller than 5 $\mu$m, there are cases where the heat-expandable microspheres after the filtration have a reduced mode diameter or productivity decreases.

The filtration may be conducted only once. However, it is preferred that several (preferably about, e.g., twice to four times) filters arranged serially be used in order to improve filtration accuracy.

The filtration using a filter may be conducted in the following manner. Heat-expandable microspheres are dispersed in water or in an adhesive (or binder) diluted with an organic solvent, and this dispersion is ejected at an appropriate pressure through a housing having a filter disposed therein. The ejection pressure can be suitably determined according to the thickness of the adherent layer and coating speed. Examples of the housing in which a filter is to be placed include Filter Housing NF-1P (manufactured by Chisso Filter Co., Ltd.). It is preferred that two or more housings arranged serially be used according to the necessity.

Separator

The separator to be used in the invention may be, for example, a base material having a surface coated with a release agent represented by a silicone resin, long-chain-alkyl acrylate resin, or fluororesin; or a lowly adhesive base material made of a nonpolar polymer such as polyethylene or polypropylene. As stated hereinabove, a separator is used as a provisional support in transferring an adherent layer or another layer onto a substrate or as a protective material which protects the adherent layer or another layer until the adhesive sheet is practically used. Incidentally, a separator is not essential.

Because of the advantages described above, the adhesive sheet of the invention may be used for permanently adhereing an adherend constituted of an appropriate article. However, the adhesive sheet is suitable for use in applications in which an adherend is kept being adhered for a given time period and, after accomplishment of the purpose of adhesion, the adhesion state is required or desired to be eliminated. In particular, the adhesive sheet is most suitable for use as a provisional fixing material during the processing of electronic parts required to be highly accurately processed or as a provisional fixing material for the cutting of a multilayered ceramic sheet.

The adherend to which the adhesive sheet of the invention is to be applied is not particularly limited. Examples thereof include semiconductor wafers (e.g., silicon wafers) and semiconductor chips for electronic parts or circuit boards, electrical products such as ceramic capacitors and oscillators, display devices such as liquid-crystal cells, thermal heads, solar cells, printed wiring boards (multilayered ceramic sheets), and green sheets for multilayered ceramic capacitors.

Method of Processing Adherend

An adherend (work) is bonded to the adherent layer in the adhesive sheet of the invention and this adherend is subjected to a processing, whereby the adherend can be processed. Steps for processing an adherend can be arbitrarily selected and may include a pressurizing step (pressing step). Specific examples of the steps for processing an adherend include the step of printing electrodes on a green sheet (e.g., pattern formation step), laminating step, pressurizing step (pressing step), cutting steps (e.g., polishing step and dicing step), and burning step. Examples thereof further include an assembling step.

The method of cutting a multilayered ceramic sheet includes, for example, the steps of (1) applying the adhesive sheet of the invention to one surface of the multilayered ceramic sheet, (2) cutting the sheet (into chips), and (3) heating the adhesive sheet to reduce the adhesive force of the adherent layer and separating the chips therefrom.

For enabling the adhesive sheet to exhibit high adhesive properties in the cutting step, it is preferred that the cutting be conducted after the adhesive sheet applied is temporarily heated. The temperature to which the adhesive sheet is heated is not particularly limited so long as it is equal to or higher than room temperature and is lower than the heat expansion initiation temperature of the heat-expandable microspheres contained in the heat-expandable adherent layer. However, it is desirable to select a temperature in the range of, for example, about 70 to 150°C (preferably 80 to 120°C, and more preferably 90 to 110°C). After the adhesive sheet has been thus heated, cutting may be conducted either at that elevated temperature or after cooling. Namely, cutting can be conducted at a temperature equal to or lower than that elevated temperature (i.e., at a temperature of from room temperature to that elevated temperature). Specifically, use may be made of a method in which the adhesive sheet is temporarily heated and then cooled to room temperature and the work is then cut at room temperature; or a method in which after the temporary heating, the work is subjected to laminating, cutting, or another processing either in the heated state or after cooling to a temperature which is higher than room temperature.

Conditions under which the adhesive sheet of the invention is heated in order to facilitate stripping thereof from the adherend can be suitably determined according to the degree of decrease in bonding area which is influenced by the surface state of the adherend, kind of the heat-expandable microspheres, etc., heat resistance of the substrate and adherend, and other factors including heating method. General heating conditions include a temperature of 100 to 250°C and a period of 1 to 90 seconds (hot plate or the like) or 5 to 15 minutes (hot-air drying oven or the like). Upon heating under such conditions, the heat-expandable microspheres in the adherent layer usually expand and the adherent layer expands/deforms, whereby the adhesive force is reduced or lost. Incidentally, the heating may be conducted in an appropriate stage according to the purpose of use. There are cases where an infrared ray lamp or heated water can be used as a heat source.

Property Examination Methods and Effect Evaluation Methods

Examination methods and effect evaluation methods used in the invention are shown below as examples.

(1) Thickness of Each of Substrate, Adherent Layer, and Adhesive Sheet

Measurement was made with a dial gauge as provided for in JIS B7503.

(2) Mode Diameter and Maximum Particle Diameter (Particle Size Distribution Examination)

Particle size distribution analyzer "SALD-2000J", manufactured by Shimadzu Corp., was used to determine the diameters by the light scattering method.

(3) Silicon Wafer Cutting Accuracy (Examples 1 and 2 and Comparative Examples 1 and 2)

The adherent-layer side of each of the adhesive sheets obtained in Examples 1 and 2 and Comparative Examples 1 and 2 was applied to a silicon wafer with "DR-8500II", manufactured by Nitto Seiki Inc., under the conditions of an application temperature of 40°C and a nip pressure of 5 :MPa. Thereafter, the silicon wafer was cut under the following conditions.

The results of the cutting were examined with an optical microscope. The adhesive sheets on which the silicon wafer suffered no positional shifting are indicated by good, while those on which positional shifting occurred are indicated by poor. Furthermore, the adhesive sheets on which the silicon wafer suffered no oblique cutting are indicated by good, while those on which oblique cutting occurred are indicated by poor.

(Cutting Conditions)

Dicer: DFD651, manufactured by Disco Corp.
Dicing speed: 60 mm/sec
Dicing blade: NBC-ZH2050HEBB, manufactured by Disco Corp.
Dicing blade rotation speed: 35,000 rpm
Dicing depth (from adhesive surface): 50 $\mu$m
Substrate cut size: 5 mm $\times$ 5 mm
Cutting mode: down cutting

(4) Bonding Area (Examples 1 and 2 and Comparative Examples 1 and 2)

The adhesive sheets obtained in Examples 1, and 2 and Comparative Examples 1 and 2 were cut into a strip form having a width of 20 mm to obtain test pieces. The adherent-layer side of each test piece was applied to a glass plate with a 2-kg roller (rolling the roller forward and backward once). The bonding area on the side applied was determined by examination with an optical microscope,

The test pieces which had a bonding area of 90% or larger are indicated by good, while those which had a bonding area smaller than 90% are indicated by poor,

(5) Adhesive Force (180° Peel Adhesive Force) (Examples 1 and 2 and Comparative Examples 1 and 2)

Adhesive sheets each applied to a glass plate in the same manner as in (4) above were examined for 180° peel adhesive force (N/20 mm) in peeling from the glass plate in accordance with JIS Z 0237.
The adhesive sheets which had a 180° peel adhesive force of 1.5 N/20 nun or higher were judged to be good, while those which had a 180° peel adhesive force lower than 1.5 N/20 mm were judged to be poor.

(6) Heat Peelability from Glass Plate (Examples 1 and 2 and Comparative Examples 1 and 2)

Adhesive sheets each applied to a glass plate in the same manner as in (4) above were heated at 130°C for 3 minutes with a thermostatic chamber (hot-air drying oven) ("SPH-201" manufactured by Espec Corp.). The adhesive sheets which, after the heating, peeled off the glass plate by themselves are indicated by good, while those which did not peel off by themselves are indicated by poor.

(7) Accuracy of Cutting of Multilayered Ceramic Sheet (Examples 3 to 8)

The adherent-layer side of each of the adhesive sheets obtained in Examples 3 to 8 was applied to a multilayered ceramic sheet on a 40°C hot plate with a rubber roller. Thereafter, the ceramic sheet was cut under the following conditions.
A section of a chip obtained by the cutting was examined with an optical microscope. The cutting accuracy Q (%) was calculated from an oblique-cutting amount a (mm) in the cut chip shown in Fig. 3 using the following equation.

$$Q\ (\%) = \{1 - (a/3.0)\} \times 100$$

(Cutting Conditions)

Ambient temperature: 60°C
Dicer: DFD651, manufactured by Disco Corp.
Dicing speed: 30 mm/sec
Dicing blade: GIA850, manufactured by Disco Corp.
Dicing blade rotation speed: 30,000 rpm
Dicing depth: 100 $\mu$m
Cut size: 3.0 mm $\times$ 3.0 mm
Cutting mode: down cutting

(8) Heat Peelability from Multilayered Ceramic Sheet (Examples 3 to 8)

In the same manner as in (7) above, each adhesive sheet was applied to a multilayered ceramic sheet and the multilayered ceramic sheet was cut. Thereafter, heat treatment was conducted at 130°C for 10 minutes with a thermostatic chamber (hot-air drying oven) ("SPH-201" manufactured by Espec Corp.). After the heating, the chips were visually examined for separation from the adhesive sheet. Each adhesive sheet from which all chips had separated was judged to be good (A), while the adhesive sheet from which not all chips had separated was judged to be poor (B).

(9) Anchoring of Adherent Layer to Substrate (Examples 3 to 8)

In the same manner as in (8) above, each adhesive sheet was applied to a multilayered ceramic sheet and cutting and heat treatment were then conducted. Thereafter, the adherent layer was visually examined for "lifting" from the substrate. The adhesive sheets in which no "lifting" was observed were judged to be good (A), while that in which "lifting" was observed was judged to be poor (B).

Examples

The invention will be explained below in more detail by reference to Examples, but the invention should not be construed as being limited by the following

Examples.

Example 1

(Preparation of Heat-Expandable Microspheres A')

Heat-expandable microspheres A (trade name "Matsumoto Microsphere F50D", manufactured by Matsumoto Yushi-Seiyaku Co., Ltd.; expansion initiation temperature, 120°C; mode diameter, 13.4 $\mu$m ; maximum particle diameter, 51.2 $\mu$m) were dispersed in pure water to prepare a 30% aqueous dispersion thereof This dispersion was subjected to three-stage filtration through filters (trade name "CP-10", manufactured by Chisso Filter Co., Ltd.; nominal filtration accuracy, 10 $\mu$m) (arranged serially) to obtain an aqueous dispersion of heat-expandable microspheres A'. The aqueous dispersion of heat-expandable microspheres A' obtained was examined for particle size distribution, and the results obtained are shown in Table 1.

(Adhesive Sheet)

A toluene solution containing 100 parts by weight of a 2-ethylhexyl acrylate/ethyl acrylate/methyl methacrylate/ 2-hydroxyethyl acrylate copolymer pressure-sensitive adhesive (monomer proportion (by weight): 50/50/5/4), 1 part by weight of an isocyanate crosslinking agent (trade name "Coronate L", manufactured by Nippon Polyurethane Co., Ltd.), and 25 parts by weight of the heat-expandable microspheres A' was prepared. This solution was applied to a polyester film (trade name "PS 100", manufactured by Teijin DuPont Films Japan Ltd.; thickness, 100 $\mu$m) as a substrate in such an amount as to result in an adherent-layer thickness of 20 $\mu$m. The solution applied was dried to form an adherent layer (heat-expandable adherent layer). Thus, an adhesive sheet (heat-peelable adhesive sheet) was obtained.

Example 2

An adhesive sheet (heat-peelable adhesive sheet) was obtained in completely the same manner as in Example 1, except that the adherent-layer thickness was changed to 38 $\mu$m.

Comparative Example 1

An adhesive sheet (heat-peelable adhesive sheet) was obtained in completely the same manner as in Example 1, except that the adherent-layer thickness was changed to 45 $\mu$m.

Comparative Example 2

Heat-expandable microspheres A" were prepared using a centrifugal classifier without using filtration through filters, in the following manner. The heat-expandable microspheres A were classified with a centrifugal classifier ("ATP-50", manufactured by Hosokawa Micron Corp.) so as to result in a mode diameter of 12.7 $\mu$m. Thus, heat-expandable microspheres A" were obtained. An aqueous dispersion obtained by dispersing the heat-expandable microspheres A" in pure water in a concentration of 30% was examined for particle size distribution. The results obtained are shown in Table 1.
An adhesive sheet (heat-peelable adhesive sheet) was obtained in the same manner as in Example 2 (adherent-layer thickness, 38 $\mu$m), except that the heat-expandable microspheres A" obtained above were used.

Table 1

| | Aqueous dispersion of heat-expandable microspheres A' | | Aqueous dispersion of heat-expandable microspheres A" | |
|---|---|---|---|---|
| | Maximum Mode diameter particle diameter | | Maximum Mode diameter particle diameter | |
| | (μm) | (μm) | (μm) | (μm) |
| Original particles (before filtration/ classification) | 13.4 | 51.2 | 13.4 | 51.2 |
| After filtration/ classification | 13.1 | 18.2 | 12.7 | 41.9 |

The adhesive sheets of Examples 1 and 2 and Comparative Examples 1 and 2 were evaluated for silicon wafer cutting accuracy, bonding area, adhesive force, and heat peelability from glass plate by the methods described above. The results obtained are shown in Table 2. As shown in Table 2, it was found that when the maximum particle diameter and mode diameter of the heat-expandable microspheres contained and the thickness of the adherent layer satisfy the requirements specified in the invention (Examples 1 and 2), then excellent adhesive sheets are obtained which, when used for silicon wafer cutting, attain high cutting accuracy and which have satisfactory adhesive properties and satisfactory heat peelability. On the other hand, it was found that when the adherent layer has too large a thickness (Comparative Example 1) or heat-expandable microspheres having too large a maximum particle diameter are used (Comparative Example 2), then only an adhesive sheet reduced in cutting accuracy, etc. and having poor performances is obtained.

Table 2

| Evaluation Item | | Unit | Example 1 | Example 2 | Comparative Example 1 | Comparative Example 2 |
|---|---|---|---|---|---|---|
| Adherent-layer thickness | | μm | 20 | 38 | 45 | 38 |
| Cutting accuracy (silicon wafer) | Positional shifting | - | good | good | poor | poor |
| | Oblique cutting | - | good | good | poor | poor |
| Bonding area | | % | 95: good | 94: good | 92: good | 48: poor |
| Adhesive force | | N/20mm | 2.5: good | 2.8: good | 2.9: good | 0.75: poor |
| Heat peelability (glass plate) | | - | natural peeling: good | natural peeling: good | natural peeling: good | natural peeling: good |
| Comprehensive judgment | | | good | good | poor | poor |

Example 3

A liquid toluene mixture containing 100 parts by weight of a 2-ethylhexyl acrylate/ethyl acrylate/methyl methacrylate/2-hdyroxyethyl acrylate copolymer pressure-sensitive adhesive (monomer proportion (by weight): 30/70/5/4), 2.0 parts by weight of an isocyanate crosslinking agent (trade name "Coronate L", manufactured by Nippon Polyurethane Co., Ltd.), 30 parts by weight of the heat-expandable microspheres A', and 10 parts by weight of a rosin phenol tackifier (trade name "YS Resin PX800", manufactured by Yasuhara Chemical Co., Ltd.) was prepared. This liquid mixture was applied to a sandblasted polyester film substrate (trade name "PS 100", manufactured by Teijin DuPont Films Japan Ltd; thickness, 100 μm; arithmetic average roughness Ra, 0.52 μm; maximum height Ry, 4.85 μm; ten-point average roughness Rz, 3.69 μm) in such an amount as to result in an adherent-layer thickness of 35 μm. The liquid mixture applied was dried to form an adherent layer (heat-expandable adherent layer). Thus, an adhesive sheet (heat-peelable adhesive sheet) was obtained.

Example 4

An adhesive sheet (heat-peelable adhesive sheet) was obtained in the same manner as in Example 3, except that a polyester film (thickness, 100 μm ; arithmetic average roughness Ra, 0.67 μm ; maximum height Ry, 6.23 μm ; ten-point average roughness Rz, 4.75 μm) which had been embossed with a metallic roll heated at 140°C and having a satin finish formed by engraving was used as a substrate.

Incidentally, the polyester film used above is trade name "PS 100", manufactured by Teijin DuPont Films Japan Ltd. The same applies to Examples 5 to 8 below.

Example 5

A liquid mixture containing 100 parts by weight of a 2-ethylhexyl acrylate/ethyl acrylate/methyl methacrylate/ 2-hdyroxyethyl acrylate copolymer pressure-sensitive adhesive (monomer proportion (by weight): 30/70/5/4), 1.5 parts by weight of an isocyanate crosslinking agent (trade name "Coronate L", manufactured by Nippon Polyurethane Co., Ltd.), 30 parts by weight of the heat-expandable microspheres A', and 5 parts by weight of a rosin phenol tackifier (trade name "Tamanol 135", manufactured by Arakawa Chemical Industries, Ltd.) was prepared.

A polyester film (thickness, 100 μm) was immersed in a dichromate treating liquid composed of 75 g of potassium dichromate, 150 g of concentrated sulfuric acid, and 120 g of water at 70°C for 10 minutes. Thereafter, the film was washed with water, neutralized, washed with water, and then dried to obtain a substrate which had undergone the dichromate treatment. The liquid mixture described above was applied to this substrate in such an amount as to result in an adherent-layer thickness of 35 μm and dried to form an adherent layer (heat-expandable adherent layer). Thus, an adhesive sheet (heat-peelable adhesive sheet) was obtained.

Example 6

A polyester film (thickness, 100 μm) was immersed in 20% sodium hydroxide solution at 80°C for 5 minutes and washed with water. Thereafter, the film was immersed in a stannous chloride solution (10 g/L) at room temperature for 10 seconds, washed with water, and then dried to obtain a substrate which had undergone the sodium hydroxide treatment. An adhesive sheet (heat-peelable adhesive sheet) was obtained in completely the same manner as in Example 5, except that the substrate was replaced by the polyester film which had undergone the sodium hydroxide treatment.

Example 7

A liquid mixture containing 100 parts by weight of a 2-ethylhexyl acrylate/ethyl acrylate/methyl methacrylate/ 2-hdyroxyethyl acrylate copolymer pressure-sensitive adhesive (monomer proportion (by weight): 30/70/5/4), 1.5 parts by weight of an isocyanate crosslinking agent (trade name "Coronate L", manufactured by Nippon Polyurethane Co., Ltd.), 30 parts by weight of the heat-expandable microspheres A', and 5 parts by weight of a rosin phenol tackifier (trade name "Tamanol 135", manufactured by Arakawa Chemical Industries, Ltd.) was prepared. This liquid mixture was applied to a polyester film substrate which had undergone corona treatment under the conditions of a corona output of 350 W, electrode spacing of 2 mm, and corona treatment speed of 10 m/min, in such an amount as to result in an adherent-layer thickness of 35 μm. The liquid mixture applied was dried to form an adherent layer (heat-expandable adherent layer). Thus, an adhesive sheet (heat-peelable adhesive sheet) was obtained.

Example 8

An adhesive sheet (heat-peetable adhesive sheet) was obtained in completely the same manner as in Example 7, except that the surface treatment of the substrate to which the liquid mixture was to be applied was replaced by sputtering treatment conducted under the conditions of a discharge power of 30 W·sec/cm$^2$, treating gas of $O_2$, and gas pressure of 3.1 Pa.

The adhesive sheets of Examples 3 to 8 were evaluated for multilayered-ceramic-sheet cutting accuracy, heat peelability from multilayered ceramic sheet, and anchoring of the adherent layer to the substrate by the methods described above. The results obtained are shown in Table 3. As shown in Table 3, it was ascertained that when the substrate surface is subjected to surface treatments according to the invention (Examples 3 to 8), a high degree of anchoring is obtained between the substrate and the adherent layer while maintaining excellent cutting accuracy and heat peelability.

Table 3

| | Adherent-layer thickness | Cutting accuracy Q | Heat peelability (ceramic sheet) | Anchoring |
|---|---|---|---|---|
| | (μm) | (%) | | |
| Example 3 | 35 | 99.2 | A | A |

(continued)

|  | Adherent-layer thickness | Cutting accuracy Q | Heat peelability (ceramic sheet) | Anchoring |
|---|---|---|---|---|
|  | ($\mu$m) | (%) |  |  |
| Example 4 | 35 | 98.6 | A | A |
| Example 5 | 35 | 99.4 | A | A |
| Example 6 | 35 | 99.0 | A | A |
| Example 7 | 35 | 99.2 | A | A |
| Example 8 | 35 | 98.6 | A | A |

While the present invention has been described in detail and with reference to specific embodiments thereof, it will be apparent to one skilled in the art that various changes and modifications can be made therein without departing from the scope thereof.

This application is based on Japanese patent application No. 2006-220839 filed August 14, 2006, the entire contents thereof being hereby incorporated by reference.

Further, all references cited herein are incorporated in their entireties.

**Claims**

1. An adhesive sheet comprising:

   a substrate; and,
   an adherent layer containing heat-expandable microspheres, the adherent layer being disposed on at least one side of the substrate,

   wherein the adherent layer has a thickness of 10 to 38 $\mu$m, and
   wherein the heat-expandable microspheres have a maximum particle diameter equal to or smaller than the thickness of the adherent layer and have a mode diameter of 5 to 30 $\mu$m.

2. The adhesive sheet according to claim 1, wherein the adherent layer is constituted of an acrylic adhesive.

3. The adhesive sheet according to claim 1, wherein a surface of the substrate on which the adherent layer is disposed has been subjected to a surface treatment.

4. The adhesive sheet according to claim 3, wherein the surface treatment is at least one member selected from the group consisting of a surface-roughening treatment, a surface treatment with a chemical, and a surface treatment with electromagnetic wave irradiation.

5. The adhesive sheet according to claim 4, wherein the surface-roughening treatment is at least one member selected from the group consisting of matting, sandblasting, and embossing.

6. The adhesive sheet according to claim 4, wherein the surface treatment with a chemical is a dichromate treatment or a sodium hydroxide treatment.

7. The adhesive sheet according to claim 4, wherein the surface treatment with electromagnetic wave irradiation is a corona treatment or a sputtering treatment.

8. The adhesive sheet according to claim 1, wherein the maximum particle diameter of the heat-expandable microspheres has been regulated so as to be equal to or smaller than the thickness of the adherent layer by filtration using a filter.

9. An adhesive sheet comprising:

   a substrate; and,

an adherent layer which is disposed on at least one side of the substrate,
the adherent layer comprising a resin layer containing heat-expandable microspheres and an adhesive layer,
the adhesive layer being disposed on a side of the resin layer which is opposite to the substrate side of the resin layer,

wherein the adherent layer has a thickness of 10 to 38 μm, and
wherein the heat-expandable microspheres have a maximum particle diameter equal to or smaller than the thickness of the adherent layer and have a mode diameter of 5 to 30 μm.

10. The adhesive sheet according to claim 9, wherein the adherent layer is constituted of an acrylic adhesive.

11. The adhesive sheet according to claim 9, wherein a surface of the substrate on which the adherent layer is disposed has been subjected to a surface treatment.

12. The adhesive sheet according to claim 11, wherein the surface treatment is at least one member selected from the group consisting of a surface-roughening treatment, a surface treatment with a chemical, and a surface treatment with electromagnetic wave irradiation.

13. The adhesive sheet according to claim 12, wherein the surface-roughening treatment is at least one member selected from the group consisting of matting, sandblasting, and embossing.

14. The adhesive sheet according to claim 12, wherein the surface treatment with a chemical is a dichromate treatment or a sodium hydroxide treatment.

15. The adhesive sheet according to claim 12, wherein the surface treatment with electromagnetic wave irradiation is a corona treatment or a sputtering treatment.

16. The adhesive sheet according to claim 9, wherein the maximum particle diameter of the heat-expandable microspheres has been regulated so as to be equal to or smaller than the thickness of the adherent layer by filtration using a filter,

17. A process for producing an adhesive sheet, which comprises:

filtering heat-expandable microspheres through a filter to regulate the heat-expandable microspheres so as to have a maximum particle diameter equal to or smaller than a thickness of an adherent layer to be formed and have a mode diameter of 5 to 30 μm; and then
forming said adherent layer containing the heat-expandable microspheres on a substrate so as to have a thickness of 10 to 38 μm,

18. The process for producing an adhesive sheet according to claim 17, wherein a surface of the substrate on which the adherent layer is to be formed is subjected to a surface treatment before the formation of the adherent layer.

19. The adhesive sheet according to claim 1, which is for use in provisional fixing in an electronic-part processing step.

20. The adhesive sheet according to claim 9, which is for use in provisional fixing in an electronic-part processing step.

21. The adhesive sheet of according to claim 1, which is for use in cutting a multilayered ceramic sheet.

22. The adhesive sheet of according to claim 9, which is for use in cutting a multilayered ceramic sheet.

23. A method of cutting a multilayered ceramic sheet, which comprises:

applying the adhesive sheet according to claim 21 to one surface of the multilayered ceramic sheet;
cutting the multilayered ceramic sheet into chips; and
heating the adhesive sheet to reduce the adhesive force of the adherent layer, followed by separating the chips from the adhesive sheet.

24. A method of cutting a multilayered ceramic sheet, which comprises:

applying the adhesive sheet according to claim 22 to one surface of the multilayered ceramic sheet;
cutting the multilayered ceramic sheet into chips; and
heating the adhesive sheet to reduce the adhesive force of the adherent layer, followed by separating the chips from the adhesive sheet.

## FIG. 1

## FIG. 2

## FIG. 3

**EP 1 889 887 A1**

European Patent Office

**EUROPEAN SEARCH REPORT**

Application Number

EP 07 01 5793

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 592 058 A (NITTO DENKO CORP [JP]) 2 November 2005 (2005-11-02) * the whole document * | 1-24 | INV. C09J7/00 |
| X | EP 1 354 925 A (NITTO DENKO CORP [JP]) 22 October 2003 (2003-10-22) * the whole document * | 1-24 | |
| X | EP 1 254 938 A (NITTO DENKO CORP [JP]) 6 November 2002 (2002-11-06) * the whole document * | 1-24 | |
| X | EP 1 156 093 A (NITTO DENKO CORP [JP]) 21 November 2001 (2001-11-21) * the whole document * | 1-24 | |
| X | EP 1 126 001 A (NITTO DENKO CORP [JP]) 22 August 2001 (2001-08-22) * the whole document * | 1-24 | |
| X | EP 1 097 977 A (NITTO DENKO CORP [JP]) 9 May 2001 (2001-05-09) * the whole document * | 1-24 | TECHNICAL FIELDS SEARCHED (IPC) C09J |
| X | EP 1 154 002 A (NITTO DENKO CORP [JP]) 14 November 2001 (2001-11-14) * the whole document * | 1-24 | |
| X | EP 0 612 823 A (NITTO DENKO CORP [JP]) 31 August 1994 (1994-08-31) * the whole document * | 1-24 | |
| X | DATABASE WPI Week 200641 Derwent Publications Ltd., London, GB; AN 2001-302261 XP002458311 & JP 2006 152308 A (NITTO DENKO CORP) 15 June 2006 (2006-06-15) * abstract * | 1-24 | |

The present search report has been drawn up for all claims

| Place of search | Date of completion of the search | Examiner |
|---|---|---|
| Munich | 13 November 2007 | Glomm, Bernhard |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                         EP 07 01 5793

This annex lists the patent family members relating to the patent documents cited in the above-mentioned European search report.
The members are as contained in the European Patent Office EDP file on
The European Patent Office is in no way liable for these particulars which are merely given for the purpose of information.

13-11-2007

| Patent document cited in search report | | Publication date | Patent family member(s) | | Publication date |
|---|---|---|---|---|---|
| EP 1592058 | A | 02-11-2005 | JP | 2005311031 A | 04-11-2005 |
| | | | KR | 20060047269 A | 18-05-2006 |
| | | | US | 2005236107 A1 | 27-10-2005 |
| EP 1354925 | A | 22-10-2003 | CN | 1451707 A | 29-10-2003 |
| | | | DE | 60304763 T2 | 14-09-2006 |
| | | | JP | 3853247 B2 | 06-12-2006 |
| | | | JP | 2003306653 A | 31-10-2003 |
| | | | SG | 107634 A1 | 29-12-2004 |
| | | | TW | 255844 B | 01-06-2006 |
| EP 1254938 | A | 06-11-2002 | CN | 1390763 A | 15-01-2003 |
| | | | DE | 60201209 D1 | 21-10-2004 |
| | | | DE | 60201209 T2 | 27-01-2005 |
| | | | JP | 2002322436 A | 08-11-2002 |
| | | | KR | 20020083145 A | 01-11-2002 |
| | | | TW | 533180 B | 21-05-2003 |
| | | | US | 2002195199 A1 | 26-12-2002 |
| EP 1156093 | A | 21-11-2001 | AT | 263818 T | 15-04-2004 |
| | | | CN | 1323865 A | 28-11-2001 |
| | | | DE | 60102618 D1 | 13-05-2004 |
| | | | DE | 60102618 T2 | 19-08-2004 |
| | | | JP | 2001323228 A | 22-11-2001 |
| | | | SG | 100702 A1 | 26-12-2003 |
| | | | TW | 254737 B | 11-05-2006 |
| | | | US | 2001055678 A1 | 27-12-2001 |
| EP 1126001 | A | 22-08-2001 | CN | 1312347 A | 12-09-2001 |
| | | | DE | 60102949 D1 | 03-06-2004 |
| | | | DE | 60102949 T2 | 02-09-2004 |
| | | | JP | 2001226650 A | 21-08-2001 |
| | | | KR | 20010082644 A | 30-08-2001 |
| | | | SG | 94755 A1 | 18-03-2003 |
| | | | TW | 546361 B | 11-08-2003 |
| | | | US | 2001019765 A1 | 06-09-2001 |
| EP 1097977 | A | 09-05-2001 | AT | 290578 T | 15-03-2005 |
| | | | CN | 1295103 A | 16-05-2001 |
| | | | DE | 60018525 D1 | 14-04-2005 |
| | | | DE | 60018525 T2 | 28-07-2005 |
| | | | JP | 3594853 B2 | 02-12-2004 |
| | | | JP | 2001131507 A | 15-05-2001 |
| | | | KR | 20010051480 A | 25-06-2001 |
| | | | KR | 20050097908 A | 10-10-2005 |
| | | | SG | 93903 A1 | 21-01-2003 |

EPO FORM P0459

For more details about this annex : see Official Journal of the European Patent Office, No. 12/82

## ANNEX TO THE EUROPEAN SEARCH REPORT
## ON EUROPEAN PATENT APPLICATION NO.

EP 07 01 5793

This annex lists the patent family members relating to the patent documents cited in the above-mentioned European search report.
The members are as contained in the European Patent Office EDP file on
The European Patent Office is in no way liable for these particulars which are merely given for the purpose of information.

13-11-2007

| Patent document cited in search report | | Publication date | Patent family member(s) | | Publication date |
|---|---|---|---|---|---|
| EP 1097977 | A | | TW | 222991 B | 01-11-2004 |
| EP 1154002 | A | 14-11-2001 | DE | 69920281 D1 | 21-10-2004 |
| | | | DE | 69920281 T2 | 27-01-2005 |
| | | | WO | 0018848 A1 | 06-04-2000 |
| | | | JP | 2000169808 A | 20-06-2000 |
| | | | TW | 225088 B | 11-12-2004 |
| EP 0612823 | A | 31-08-1994 | DE | 69403012 D1 | 12-06-1997 |
| | | | DE | 69403012 T2 | 14-08-1997 |
| | | | JP | 3308672 B2 | 29-07-2002 |
| | | | JP | 6306337 A | 01-11-1994 |
| | | | US | 5441810 A | 15-08-1995 |
| JP 2006152308 | A | 15-06-2006 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 50013878 B
- JP 51024534 B
- JP 56061468 A
- JP 56061469 A
- JP 60252681 A
- JP 56061483 A
- JP 61174857 A
- JP 63017981 A
- JP 56013040 A
- JP 2006220839 A